**Europäisches Patentamt**

**European Patent Office**

**Office européen des brevets**

(19)

(11) Numéro de publication: **0 341 117**
**B1**

## FASCICULE DE BREVET EUROPEEN

(12)

(45) Date de publication du fascicule du brevet:
22.08.90

(51) Int. Cl.⁵: **G01R 31/02**

(21) Numéro de dépôt: 89401112.1

(22) Date de dépôt: 20.04.89

(54) Dispositif pour détecter les coupures et les court-circuits dans au moins une portion de circuit électrique.

(30) Priorité: 04.05.88 FR 8806003

(43) Date de publication de la demande:
08.11.89 Bulletin 89/45

(45) Mention de la délivrance du brevet:
22.08.90 Bulletin 90/34

(84) Etats contractants désignés:
AT DE FR GB IT NL SE

(56) Documents cités:
DE-A- 2 614 748
FR-A- 1 496 316
US-A- 3 771 048
US-A- 4 470 041

IBM TECHNICAL DISCLOSURE BULLETIN,
vol.24,no.7B,Décembre 1981,pages 3743-3744,IBM
Corp.;R.F.KORSCH:"Switch tester"

(73) Titulaire: BULL S.A., 121, Avenue de Malakoff,
F-75116 Paris(FR)

(72) Inventeur: Champiau, Robert, 56, avenue de Séquigny,
F-91360 Villemoisson sur Orge(FR)

(74) Mandataire: Davroux, Yves et al, BULL S.A. Industrial
Property Department P.C.:
HQ 8M006 B.P. 193.16 121 avenue de Malakoff,
F-75764 Paris Cédex 16(FR)

ACTORUM AG

## Description

La présente invention se rapporte à un dipositif pour détecter les coupures et les court-circuits dans au moins une portion de circuit électrique formée d'au moins un élément non capacitif intercalé entre deux organes interrupteurs. Un tel dispositif détecteur trouve plus particulièrement, quoique non exclusivement, son application dans la détection des défauts survenant dans les ensembles matriciels tels que, par exemple, ceux qui sont habituellement utilisés pour commander les têtes magnétiques d'un dispositif d'enregistrement magnétique.

Depuis plusieurs dizaines d'années, on a réalisé, pour l'enregistrement des informations, des dispositifs d'enregistrement magnétique qui, tels que les mémoires à tambour magnétique ou les imprimantes magnétographiques par exemple, comportent un support d'enregistrement magnétique constitué le plus souvent par un tambour magnétique ou une courroie sans fin revêtue d'une couche magnétique. L'enregistrement des informations sur ce support est effectué au moyen d'un organe d'enregistrement comportant plusieurs têtes d'enregistrement magnétique à proximité desquelles se déplace ce support d'enregistrement. Chacune de ces têtes engendre, chaque fois qu'elle est excitée pendant un court instant par un courant électrique d'intensité convenable, un champ magnétique qui a pour effet de créer, sur la surface du support d'enregistrement qui défile devant ces têtes des domaines magnétisés de petites dimensions, ces domaines, pratiquement ponctuels, étant généralement désignés sous le nom de points magnétisés.

Ces têtes, qui sont constituées chacune d'un noyau magnétique autour duquel a été bobiné un enroulement d'excitation, sont habituellement disposées les unes à côté des autres et alignées suivant une direction perpendiculaire à la direction de déplacement du support d'enregistrement. Les enroulements d'excitation de ces têtes sont commandés par un circuit d'excitation électrique qui, du point de vue exploitation, présente le plus souvent, une structure de type matriciel. En d'autres termes, dans cette structure, les enroulements d'excitation des têtes sont répartis en p groupes comprenant chacun n enroulements, l'une des extrémités de chaque enroulement étant connectée à l'une des bornes d'une source de courant par l'intermédiaire de l'un de n premiers organes interrupteurs, chacun de ces n organes étant associé respectivement à un enroulement correspondant des n enroulements de chaque groupe, l'autre extrémité de chaque enroulement étant connectée à l'autre borne de cette source par l'intermédiaire de l'un de p seconds organes interrupteurs, ces p organes interrupteurs étant associés chacun respectivement à un groupe correspondant des p groupes d'enroulements. On comprend, dans ces conditions, que l'excitation, électrique d'un enroulement est obtenue en fermant simultanément le premier organe interrupteur qui est associé à cet enroulement et le second organe interrupteur qui est associé au groupe dont cet enroulement fait partie. En définitive, en fonctionnement normal, la fermeture simultanée d'un premier organe interrupteur et d'un second organe interrupteur a toujours pour effet, si le circuit d'excitation ne présente aucun défaut, de faire circuler un courant électrique dans une portion de circuit constituée par ces deux organes interrupteurs et par l'enroulement dont les extrémités sont reliées à ces deux organes interrupteurs.

Il peut arriver cependant qu'une coupure se produise dans cette portion de circuit, cette coupure pouvant être due, soit à une fermeture défectueuse de l'un au moins des deux organes interrupteurs de cette portion, par suite d'une usure par exemple, soit à un sectionnement de l'enroulement ou à une cassure des soudures qui connectent cet enroulement à ces deux organes interrupteurs. Dans ce cas, on ne peut, lorsqu'on veut fermer ces deux organes interrupteurs, obtenir une excitation de l'enroulement qui est intercalé entre ces deux organes. Inversement, il peut arriver qu'un organe interrupteur qui a été placé en position de fermeture reste bloqué dans cette position à la fin de la période normale de fermeture. Dans ce cas, l'un des enroulements dont l'une des extrémités est reliée à cet organe interrupteur se trouvera involontairement excité lorsqu'on fermera l'autre organe interrupteur qui est connecté à l'autre extrémité de cet enroulement. Cette excitation involontaire se traduira donc par l'enregistrement d'une information indésirable sur la surface du support d'enregistrement.

Afin d'éliminer les risques d'erreurs d'enregistrement consécutifs à une coupure, à un mauvais contact à un court-circuit survenant dans une portion du circuit d'excitation électrique, on a proposé, dans l'art antérieur, divers dispositifs de détection capables de déceler les défauts de fonctionnement d'un tel circuit. C'est ainsi que l'on connaît un dispositif de vérification qui a été décrit dans le brevet français N° 1.496.316 et qui, pour détecter que l'enroulement d'excitation bobiné autour du noyau d'une tête d'enregistrement magnétique a bien été excité par des signaux de commande d'enregistrement délivrés par un circuit de commande, comporte un enroulement supplémentaire bobiné autour du noyau de cette tête et un comparateur chargé, d'une part de comparer les signaux qui sont induits dans cet enroulement supplémentaire avec ceux qui ont été délivrés par le circuit de commande, d'autre part d'engendrer un signal indicatif d'erreur lorsque la concordance entre les signaux comparés n'est pas établie.

On connaît également un dispositif détecteur de défaut de fontionnement qui a été décrit dans la publication "IBM Technical Disclosure Bulletin", Vol. 27, N° 9, Février 1985, pages 5464-5465, et qui, constitué d'un circuit analogique branché en dérivation aux bornes d'une résistance insérée dans la portion de circuit à tester, délivre un signal indicatif d'erreur lorsque l'intensité du courant circulant dans cette portion est supérieure à une valeur de seuil prédéterminée.

Ces dispositifs de détection conviennent bien pour déceler les défauts de fonctionnement qui se produisent dans un circuit comportant un petit nombre de portions de circuit. Mais leur application, pour déceler les défauts survenant dans un grand nombre de portions de circuit, ne saurait être envisagée pour la raison que le nombre des dispositifs nécessaires à cette détection devrait être alors égal à celui des portions de circuit à tester, ce qui, naturellement, aurait pour effet d'augmenter notablement le prix de revient des machines dans lesquelles ces dispositifs seraient montés.

En outre, avec ces dispositifs, la vérification de l'état d'une portion de circuit ne peut s'effectuer que si cette portion de circuit est parcourue par un courant électrique dont l'intensité est égale à une valeur fixe déterminée. C'est ainsi, par exemple, que l'état de l'enroulement d'excitation d'une tête d'enregistrement magnétique n'est vérifié que lorsque cet enroulement est traversé par un courant dont l'intensité est suffisante pour provoquer l'enregistrement d'une information sur le support d'enregistrement. Dans le cas où cet enroulement d'excitation serait coupé, l'absence de signal induit dans l'enroulement supplémentaire de cette tête indiquerait alors la présence d'un défaut dans l'enroulement d'excitation. Si, maintenant, l'enroulement d'excitation de cette tête n'étant pas coupé, on réduisait notablement l'intensité du courant circulant dans cet enroulement, dans le but de vérifier seulement l'état de cet enroulement sans pour cela enregistrer d'information sur le support d'enregistrement, on ne pourrait, avec ce dispositif, déterminer le bon état de l'enroulement d'excitation de cette tête, étant donné que l'amplitude du signal induit dans l'enroulement supplémentaire de cette tête serait nulle ou beaucoup trop faible pour permettre de conclure avec certitude à l'absence de défaut dans l'enroulement d'excitation.

En définitive, ces dispositifs de détection se révèlent incapables de vérifier l'état de portions de circuit, en dehors des périodes d'excitation normales de ces portions.

La présente invention remédie à ces inconvénients et propose un dispositif de détection qui, tout en étant de structure relativement simple, est capable de vérifier l'état d'un grand nombre de portions de circuit, cette vérification s'effectuant en dehors des périodes d'excitation normales de ces portions de circuit. Ce dispositif de détection est établi pour détecter les coupures et les court-circuits survenant dans au moins une portion de circuit comprenant au moins un élément passif non capacitif, tel qu'une résistance, une diode, une bobine, cet élément étant intercalé entre deux organes interrupteurs, ces organes pouvant consister en des contacts à relais ou des transistors.

Plus précisément, la présente invention concerne un dispositif pour détecter les coupures et les court-circuits survenant dans au moins une portion de circuit électrique formée d'au moins un élément passif non capacitif présentant une première extrémité et une seconde extrémité, d'un premier organe interrupteur actionnable sélectivement et monté entre ladite première extrémité et une première borne d'une source de tension continue, et d'un second organe interrupteur actionnable sélectivement, indépendamment de l'actionnement dudit premier organe interrupteur, et monté entre ladite seconde extrémité et la seconde borne de ladite source de tension, ce dispositif étant caractérisé en ce qu'il comprend un circuit discriminateur, pourvu, d'une part d'une entrée connectée à ladite première extrémité, d'autre part de quatre sorties, ce circuit discriminateur étant établi pour délivrer une configuration différente de signaux sur ses sorties, selon que chacune des deux parties de ladite portion de circuit qui sont situées de part et d'autre de ladite première extrémité présente un défaut de coupure ou un défaut de court-circuit, consécutivement à l'actionnement des deux organes interrupteurs.

L'invention sera mieux comprise et d'autre buts, détails et avantages de celle-ci apparaîtront mieux dans la description suivante, donnée à titre d'exemple non limitatif, et en se référant aux dessins annexés sur lesquels :

- La figure 1 représente le schéma général d'un dispositif de détection établi selon l'invention, dans son application à la détection de défauts pouvant survenir dans une seule portion de circuit électrique.
- Les figures 2A, 2B et 2C représentent, lorsqu'elles sont assemblées, le schéma de détail d'un dispositif de détection établi selon l'invention, dans son application à la détection des défauts survenant dans les enroulements et dans le circuit de commande d'excitation des têtes d'un dispositif d'enregistrement magnétique, et,

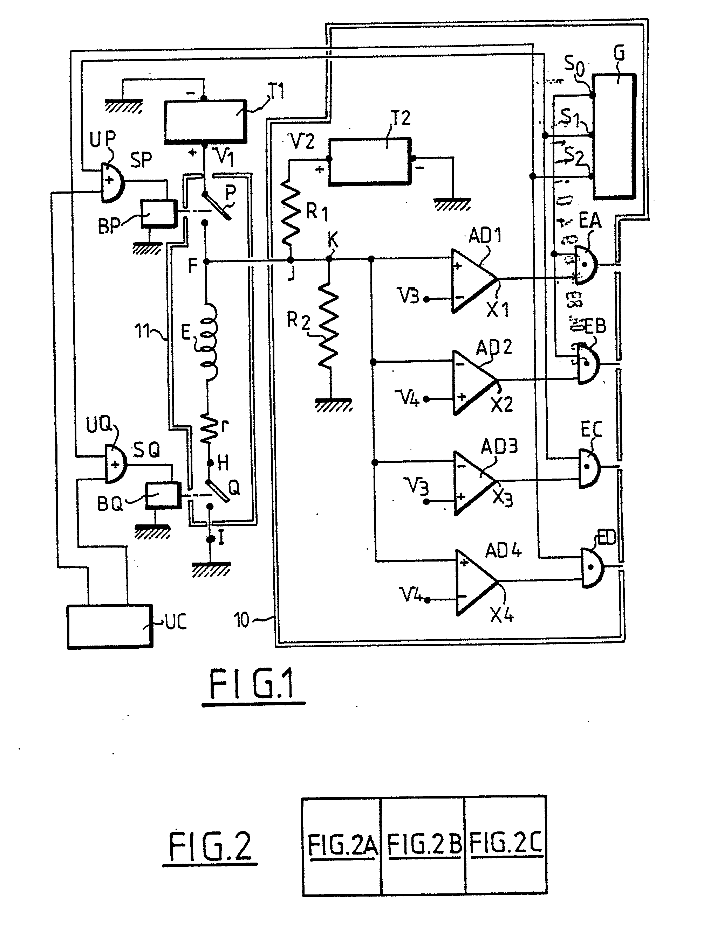

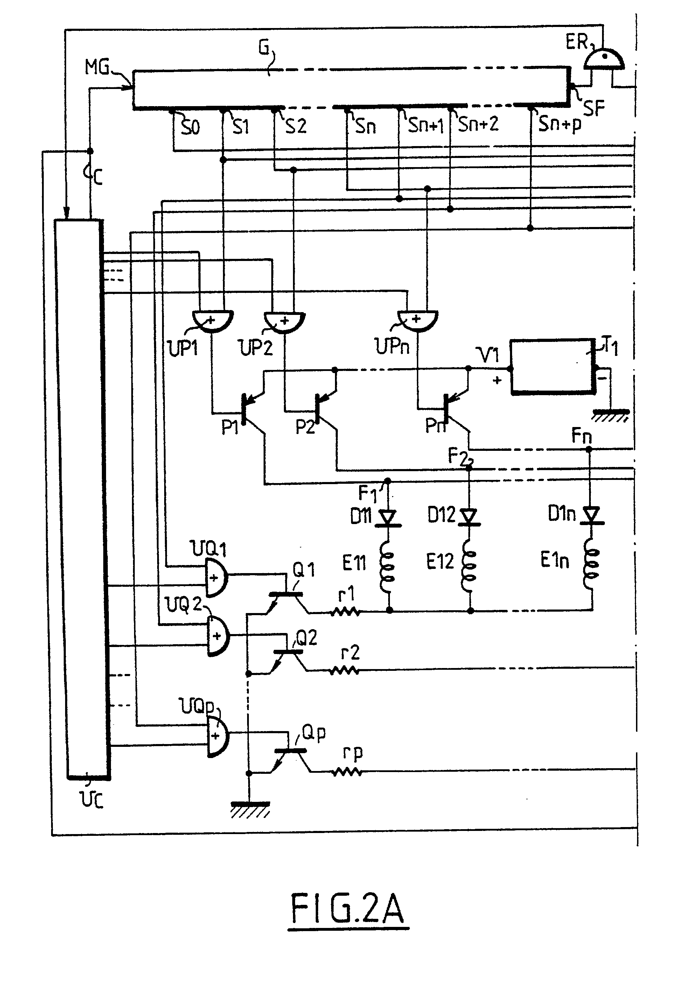

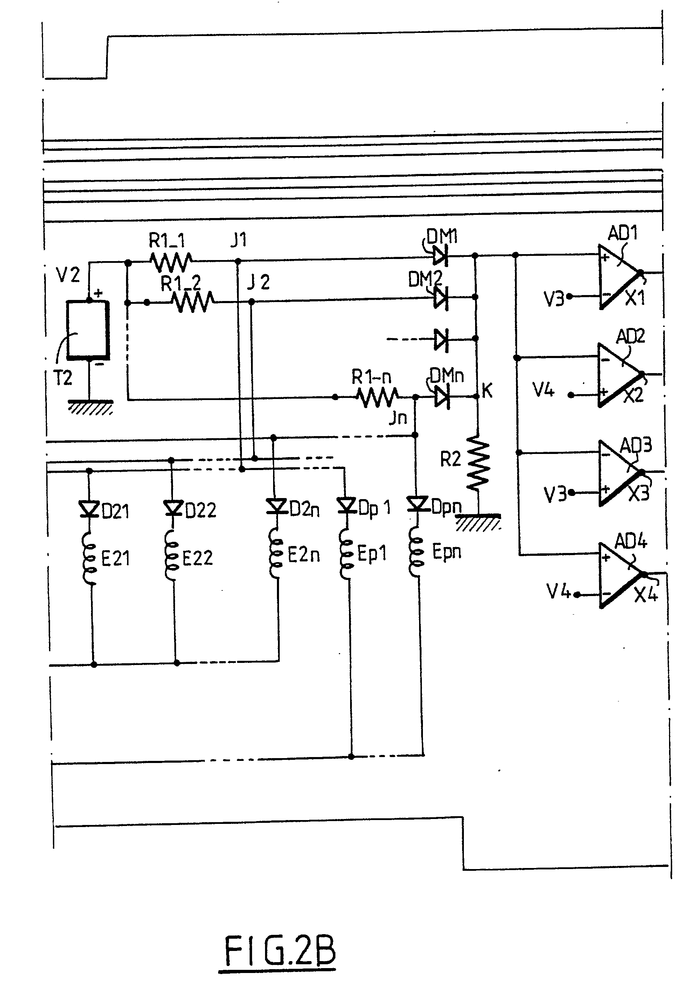

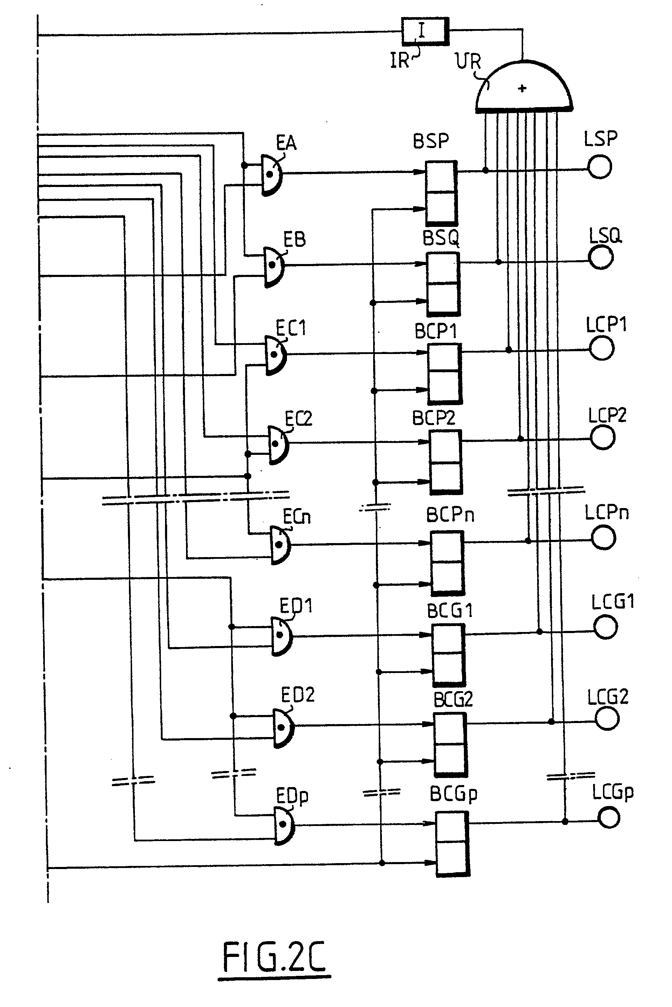

- La figure 2 montre la façon dont sont assemblées les figures 2A, 2B et 2C.

La figure 1 destinée à montrer la constitution générale d'un dispositif de détection 10 qui est réalisé selon l'invention pour détecter les coupures ou les court-circuits pouvant survenir dans une portion de circuit électrique. Dans l'exemple illustré sur cette figure, cette portion de circuit, qui a été symboliquement représentée à l'intérieur d'un contour désigné par la référence 11, comprend un premier organe interrupteur P, un enroulement E, une résistance r et un second organe interrupteur Q, tous ces éléments étant montés en série de manière que cet enroulement E et cette résistance r se trouvent intercalés entre les deux organes interrupteurs P et Q, l'ensemble de tous ces éléments étant branché aux bornes d'une source de tension continue T1. Plus précisément, la borne positive (+) de cette source T1 étant reliée à l'organe interrupteur P, la borne négative (-) de cette source est reliée à la terre, de même que la borne libre I de l'organe interrupteur Q. Il faut signaler par ailleurs que la résistance r peut aussi bien représenter la résistance de l'enroulement E qu'une résistance quelconque qui serait montée en série avec cet enroulement et dont la valeur tiendrait compte de la résistance de cet enroulement. Sur la figure 1, on a désigné par V1 la valeur du potentiel de la borne (+) de la source T1 par rapport à la terre. On a, en outre, désigné par F la borne du premier organe interrupteur P qui est reliée à l'une des extrémités de l'enroulement E, et par H la borne du second organe interrupteur Q qui est reliée à l'une des extrémités de la résistance r.

Dans l'exemple illustré par la figure 1, on considèrera que les deux organes interrupteurs P et Q sont constitués par des contacts placés chacun respectivement sous la commande de deux bobines de relais BP et BQ. Chacun de ces contacts reste normalement ouverte aussi longtemps que la bobine qui le commande n'est pas excitée. Au contraire, chaque fois qu'une tension électrique SP est appliquée à la bobine BP, cette bobine se trouve excitée et ferme son contact P. De même, chaque fois qu'une tension électrique SQ est appliquée à la bobine BQ, cette bobine se trouve excitée et ferme son contact Q. On comprend, dans ces conditions, que, normalement, lorsque les tensions électriques SP et SQ sont appliquées simultanément aux bobines BP et BQ, les contacts P et Q se ferment simultanément, de sorte qu'un courant continu circule, à partir de la borne + de la source T1, dans la portion de circuit 11 constituée par les deux contacts P et Q, l'enroulement E et la résistance r.

Il peut arriver cependant que, par suite d'une usure par exemple, le contact P se ferme mal, ou même ne se ferme pas du tout, lorsqu'on applique une tension à la bobine BP. On dit alors que le contact P, qui est sollicité en position de fermeture, présente un défaut de coupure. Dans ce cas, aucun courant électrique ne peut circuler dans la portion de circuit 11. D'une manière plus générale, cette portion de circuit ne peut être parcourue par un courant électrique, lorsque les bobines BP et BQ sont excitées toutes les deux, que si cette portion ne comporte pas de coupure, cette coupure pouvant être due aussi bien à un défaut de fermeture des contacts P et Q qu'à tout autre coupure accidentelle telle que, par exemple, la rupture de l'une des soudures qui ont été effectuées pour raccorder entre eux les différents éléments de cette portion de circuit.

Ainsi qu'on le verra plus loin, le dispositif de détection 10 est établi pour détecter la présence d'une coupure accidentelle quelconque dans cette portion de circuit 11.

Il peut arriver maintenant que, par suite, par exemple, d'une diminution de l'élasticité de la lame constitutive du contact P, ce contact, qui a été fermé consécutivement à l'application d'une tension sur la bobine BP, reste fermé après la disparition de cette tension. On dit alors que le contact P, qui se trouve sollicité en position d'ouverture, présente un défaut de court-circuit. Dans ces conditions, si, pour des raisons qui apparaîtront plus loin, on est amené à appliquer une tension SQ à la bobine BQ afin de fermer le contact Q sans pour cela chercher à exciter l'enroulement E, un courant électrique indésirable, dit de court-circuit, traversera nécessairement cet enroulement E et la résistance r. De même, un courant de court-circuit circulera dans l'enroulement E et la résistance r dans le cas où le contact Q se trouve en court-circuit et où une tension est appliquée seulement à la bobine BP pour fermer le contact P. Le dispositif de détection 10 permet justement, comme on le verra plus loin, de détecter les court-circuits accidentels présentés par les contacts P et Q.

Avant de décrire la structure du dispositif de détection 10, il est utile d'indiquer que les tensions SP et SQ qui sont appliquées simultanément aux bobines BP et BQ pendant les périodes d'excitation normales de l'enroulement E, proviennent d'une unité de commande UC et sont transmises à ces bobines BP et BP par l'intermédiaire, respectivement, d'un circuit "OU" UP et d'un circuit "OU" UQ.

Ces tensions qui sont ainsi appliquées en même temps aux bobines BP et BQ, provoquent la fermeture simultanée des contacts P et Q. Par suite, l'enroulement E est parcouru par un courant électrique d'intensité relativement élevée, c'est-à-dire par un courant électrique dont l'intensité, dans l'exemple décrit, est de l'ordre de 240 mA. On n'insistera pas davantage sur ce mode d'excitation normale de l'enroulement E, étant donné qu'il n'est pas, à proprement parler, concerné par la présente invention. Mais il faut signaler que le dispositif de détection 10, qui va être maintenant décrit, est établi pour contrôler l'état de la portion de circuit 11 en dehors des périodes d'excitation normales de l'enroulement E, c'est-à-dire en dehors des périodes où l'unité de commande UC délivre des tensions destinées à exciter simultanément les bobines BP et BQ.

Ainsi qu'on le voit sur la figure 1, le dispositif de détection 10 comprend deux résistances R1 et R2 dont l'une R1 présente une extrémité J reliée à une extrémité K de l'autre résistance R2, ces deux résistances étant ainsi montées en série entre la borne positive + d'une deuxième source de tension continue T2 et la terre, la borne négative de cette source étant elle-même mise à la terre, de même que l'autre extrémité de la résistance R2. Sur la figure 1, on a désigné par V2 la valeur du potentiel auquel se trouve la borne positive + de la source de tension T2 par rapport à la terre. Le dispositif de détection 10 comprend en outre quatre amplificateurs différentiels AD1, AD2, AD3 et AD4 de type connu. Les entrées inverseuses (-) des amplificateurs AD2 et AD3 et les entrées non inverseuses (+) des amplificateurs AD1 et AD4 sont toutes connectées entre elles à l'extrémité K de la résistance R2. L'extrémité J de la résistance R1, qui est connectée à cette extrémité K, est reliée, par ailleurs, à la borne F du contact P. L'entrée inverseuse (-) de l'amplificateur AD1 et l'entrée non inverseuse (+) de l'amplificateur AD3 reçoivent chacune une tension continue stable de référence, de valeur V3. L'entrée non inverseuse (+) de l'amplificateur AD2 et l'entrée inverseuse (-) de l'amplificateur AD4 reçoivent chacune une autre tension continue stable de référence, de valeur V4. La valeur de la résistance R2 est choisie relativement élevée afin, d'une part, de limiter à une valeur convenable l'intensité du courant qui, lorsque le contact P est fermé, s'écoule vers la terre à partir de la borne (+) de la source T1, par l'intermédiaire du contact P fermé et de la résistance R2, et, d'autre part, d'éviter que, pendant les périodes d'excitation normales où les contacts P et Q sont tous les deux fermés, l'intensité du courant qui circule alors dans l'enroulement E, ne se trouve considérablement affaiblie par rapport à celle du courant qui traverserait cet enroulement si la liaison établie entre la borne F et la terre, par l'intermédiaire de la résistance R2, n'existait pas. C'est ainsi que, dans l'exemple de réalisation illustré sur la figure 1, la valeur de R2 est de l'ordre de huit cent à mille fois celle de la résistance r, cette dernière ayant une valeur de l'ordre d'une cinquantaine d'ohms. De même, la valeur de la résistance R1 est choisie relativement élevée afin d'éviter que, lorsque le contact Q est fermé et le contact P ouvert, l'enroulement E ne soit traversé par un courant relativement important, ce courant s'écoulant vers la terre, à partir de la borne (+) de la source T2, par l'intermédiaire de la résistance R1, de l'enroulement E, de la résistance r et du contact Q fermé. La source T2 et la résistance R1 sont choisies par ailleurs de manière que, lorsque les contacts P et Q sont ouverts tous les deux, les points F, J et K se trouvent portés à un potentiel dont la valeur V5, par rapport à la terre, est nettement inférieure à celle V1 du potentiel de la borne (+) de la source T1, la valeur V5 de ce potentiel pouvant être par exemple égale au tiers de cette valeur V1. C'est ainsi que, dans l'exemple décrit où la source T1 présente entre ses bornes une tension V1 pratiquement égale à douze volts, la source T2 est choisie de façon à présenter entre ses bornes une tension V2 pratiquement égale à cinq volts et la résistance R1 est choisie de manière que sa valeur soit pratiquement le quart de celle de la résistance R2, de sorte que, lorsque les contacts P et Q sont ouverts, les points F, J et K se trouvent pratiquement portés à un potentiel de quatre volts par rapport à la terre. La valeur V3 de la tension de référence qui est appliquée sur l'entrée inverseuse de AD1 et sur l'entrée non inverseuse de AD3 est choisie de manière à être comprise entre la valeur V1 du potentiel de la borne positive (+) de la source T1 et la valeur V5 du potentiel auquel se trouve le point K lorsque les contacts P et Q sont ouverts. La valeur V4 de la tension de référence qui est apliquée sur l'entrée non inverseuse de AD2 et sur l'entrée inverseuse de AD4 est choisie de manière à être inférieure à cette valeur V5. C'est ainsi que, dans l'exemple décrit où V5 est pratiquement égal à quatre volts, les valeurs de V3 et V4 sont choisies égales, respectivement, à sept volts et à deux volts.

L'amplificateur différentiel AD1 est conçu, de manière connue, pour délivrer un signal continu sur sa sortie X1 lorsque le potentiel du point K devient supérieur à la valeur de la tension de référence V3. De même, l'amplificateur différentiel AD2 est conçu pour délivrer un signal continu sur sa sortie X2 lorsque le potentiel du point K devient inférieur à la valeur de la tension de référence V4. Pareillement, l'amplificateur différentiel AD3 est conçu pour délivrer un signal continu sur sa sortie X3 lorsque le potentiel du point K devient inférieur à la valeur de la tension de référence V3. Enfin, l'amplificateur différentiel AD4 est conçu pour délivrer un signal continu sur sa sortie X4 lorsque le potentiel du point K devient supérieur à la valeur de la tension de référence V4.

Afin de contrôler l'état de la portion de circuit dont la constitution a été indiquée plus haut, le dispositif de détection qui est représenté sur la figure 1 comprend encore un générateur de signaux G qui est déclenché, d'une manière qui sera indiquée plus loin, à la fin d'une période d'excitation normale de l'enroulement E, ce générateur étant ici pourvu de trois sorties $S_0$, $S_1$ et $S_2$ et étant établi pour, à partir de l'instant où il est déclenché, délivrer une impulsion positive, sur successivement chacune de ses trois sorties. La première impulsion, qui apparaît à la sortie So du générateur G, est appliquée à l'une des entrées de deux circuits "ET" EA et EB, chacun de ces circuits comportant deux entrées. Ces deux circuits EA et EB ont leur autre entrée connectée respectivement à la sortie X1 de l'amplificateur différentiel AD1 et à la sortie X2 de l'amplificateur différentiel AD2. Au moment où la première impulsion apparaît à la sortie So du générateur G, les bobines BP et BQ ne sont pas excitées. Dans ces conditions, si la portion de circuit 11 à tester ne comporte pas de défauts, les contacts P et Q sont ouverts. Par suite, ainsi qu'on l'a expliqué plus haut, le point K se trouve porté au potentiel V5 (on rappelle que, dans l'exemple décrit, V5 = 4 volts), et par conséquent aucun signal n'apparaît aux sorties X1 et X2 des amplificateurs différentiels AD1 et AD2. De ce fait, les circuits EA et EB, en réponse à l'impulsion qui, envoyée par la sortie S0, est appliquée sur l'une de leurs deux entrées, ne délivrent aucun signal à leurs sorties.

Si, au contraire, le contact P se trouve en court-circuit, c'est-à-dire fermé alors que la bobine BP n'est pas excitée, le point K se trouve porté au potentiel V1 (ce potentiel étant égal à 12 volts dans l'exemple décrit). Dans ce cas, étant donné que le potentiel en K est supérieur à V3, l'amplificateur différentiel AD1 délivre un signal à sa sortie X1. Par suite, le circuit EA, lorsqu'il reçoit l'impulsion envoyée par la sortie So, délivre un signal à sa sortie, ce signal indiquant alors que le contact P est en court-circuit.

Si, maintenant, le contact P n'est pas en court-circuit, c'est-à-dire reste ouvert, mais que le contact Q se trouve en court-circuit, l'enroulement E est parcouru par un courant qui, à partir de la borne positive de la source T2, s'écoule vers la terre, ce courant ayant une intensité dont la valeur $I_1$ est donnée par l'expression :

$$I_1 = \frac{R2}{(R2 + r)\,R1 + R2.r} \cdot V2$$

Par suite, le point K est porté à un potentiel dont la valeur V6, par rapport à la terre, est donnée par :
V6 = r.$I_1$
c'est-à-dire :

$$V6 = \frac{R2.r}{(R2 + r)\,R1 + R2.r} \cdot V2$$

ou, compte-tenu du fait que la valeur de r est négligeable par rapport à celle de R2 et à celle de R1 :

$$V6 \simeq \frac{r}{R1} \cdot V2$$

Les ordres de grandeurs des résistances R1 et r et de la tenson V2 qui ont été donnés plus haut montrent que le potentiel V6 en K est très proche de zéro. En effet, dans l'exemple décrit où la tension V2 est pratiquement égale à cinq volts et où les résistances r et R1 ont des valeurs pratiquement égales, respectivement, à cinquante ohms et à dix mille ohms, ce potentiel V6 a sensiblement pour valeur :

$$V6 = \frac{50}{10\ 000} \cdot 5 = 25\ mV.$$

En conséquence, étant donné que ce potentiel V6 est inférieur à V4 (V4 étant égal à 2 volts dans l'exemple décrit), l'amplificateur différentiel AD2 délivre un signal à sa sortie X2. Par suite, le circuit EB, lorsqu'il reçoit l'impulsion envoyée par la sortie So du générateur G, délivre un signal à sa sortie, ce signal indiquant alors que le contact Q est en court-circuit.

La figure 1 montre encore que la deuxième impulsion, qui apparaît ensuite à la sortie $S_1$ du générateur de signaux G, est appliquée, d'une part à l'une des deux entrées d'un circuit "ET" EC, l'autre entrée de ce circuit EC étant connectée à la sortie X3 de l'amplificateur différentiel AD3, d'autre part, par l'intermédiaire du circuit UP, à la bobine BP. La bobine BP, excitée par cette impulsion, ferme alors momentanément son contact P. Si, pendant cette période d'excitation, la fermeture du contact P s'effectue correctement, le point K se trouve mis temporairement au potentiel de la borne positive de la source T1, c'est-à-dire au potentiel V1. Etant donné alors que le potentiel du point K est supérieur à V3, l'amplificateur AD3 ne délivre aucun signal à sa sortie X3. Par suite, le circuit EC, qui ne reçoit que l'impulsion provenant de la sortie $S_1$, ne délivre aucun signal à sa sortie.

Il peut arriver, au contraire, que, pendant la période d'excitation de la bobine BP, une coupure subsiste dans la partie de la portion 11 qui est comprise entre la borne positive de la source T1 et la borne F, cette coupure pouvant être due, soit à une fermeture défectueuse du contact P, soit à une cassure des fils ou des soudures effectuées au niveau des bornes de ce contact P ou de la source T1. Dans ce cas, le point K reste au même potentiel que lorsque les contacts P et Q sont ouverts, c'est-à-dire au potentiel V5. Du fait que le potentiel du point K est alors inférieur à V3 (c'est-à-dire à sept volts dans l'exemple décrit), l'amplificateur AD3 délivre un signal sur sa sortie X3. Par suite, le circuit EC, qui reçoit simultanément ce signal et l'impulsion émise à la sortie $S_1$ du générateur G, délivre un signal à sa sortie, ce signal indiquant alors qu'une coupure s'est produite dans la partie du circuit 11 qui est comprise entre la borne F et la borne positive de la source T1.

La troisième impulsion, qui apparaît enfin à la sortie $S_2$ du générateur G, est appliquée, comme le montre la figure 1, d'une part à l'une des deux entrées d'un circuit "ET" ED, l'autre entrée de ce circuit étant connectée à la sortie X4 de l'amplificateur différentiel AD4, d'autre part, par l'intermédiaire du circuit UQ, à la bobine BQ. La bobine BQ, excitée par cette impulsion, ferme alors momentanément son contact Q. Si, pendant cette période d'excitation, la fermeture du contact Q s'effectue correctement, le point K se trouve mis temporairement au potentiel V6 indiqué plus haut (on rappelle que, dans l'exemple décrit, la valeur de V6 est de l'ordre de 25 millivolts). Etant donné alors que le potentiel du point K est inférieur au potentiel V4, l'amplificateur AD4 ne délivre aucun signal à sa sortie X4. Par suite, le circuit ED, qui ne reçoit que l'impulsion provenant de la sortie $S_2$, ne délivre aucun signal à sa sortie.

Il peut arriver, au contraire, que , pendant la période d'excitation de la bobine BQ, une coupure subsiste dans la partie du circuit 11 qui, comportant l'enroulement E et la résistance r, est comprise entre la borne F et la terre, cette coupure pouvant être due, soit à une fermeture défectueuse du contact Q, soit à une cassure des fils de liaison ou des conducteurs constituant l'enroulement E et la résistance r, soit encore à une rupture des soudures entreprises pour connecter entre eux les éléments constitutifs de cette partie de circuit. Dans ce cas, le point K reste au potentiel V5, ce potentiel étant supérieur au potentiel de référence V4. En conséquence, l'amplificateur AD4 délivre un signal sur sa sortie X et, par suite, le circuit ED, qui reçoit simultanément ce signal et l'impulsion émise à la sortie $S_2$ du générateur, délivre un signal à sa sortie, ce dernier signal indiquant ainsi qu'une coupure s'est produite dans la partie du circuit 11 qui est comprise entre la borne F et la terre.

D'après les explications qui ont été données ci-dessus, on comprend que les quatre circuits "ET" EA, EB, EC et ED jouent le rôle de circuits de validation pour les signaux qui, en cas de défauts, sont délivrés sur les sorties X1, X2, X3 et X4 des amplificateurs différentiels AD1, AD2, AD3 et AD4. En effet, les circuits EA et EB permettent, lorsque les contacts P et Q sont tous les deux sollicités en position d'ouverture, de ne tenir compte que des signaux qui, en cas court-circuit, apparaissent sur l'une des sorties X1 et X2. De même, le circuit EC permet, lorsque le contact Q est ouvert et le contact P fermé, de ne tenir compte que du signal qui, en cas de coupure dans la partie comprise entre la borne positive de T1 et le point F, apparaît sur la sortie X3. Enfin, le circuit ED permet, lorsque le contact P est ouvert et le contact Q fermé, de ne tenir compte que du signal qui, en cas de coupure dans la partie comprise entre le point F et la terre, apparaît sur la sortie X4.

Il y a lieu de signaler que, dans le cas exceptionnel où les contacts P et Q présentent tous les deux un défaut de court-circuit, le point K se trouve porté au potentiel V1. Dans ce cas, l'amplificateur AD1 délivre bien un signal à sa sortie X1, alors que l'amplificateur AD2 ne délivre aucun signal à sa sortie X2, et cela bien que le contact Q se trouve en court-circuit. En conséquence, l'absence de signal à la sortie X2 ne pourra être interprétée comme indiquant l'absence de défaut de court-circuit du contact Q que si le contact P ne présente pas lui-même un défaut de court-circuit.

Il convient de remarquer encore que, au cours du contrôle entrepris par le dispositif de détection 10 pour vérifier l'état de la portion de circuit 11, l'enroulement E n'est jamais parcouru par un courant d'intensité élevée, sauf, cependant, dans le cas exceptionnel où les deux contacts P et Q se trouvent tous les deux en court-circuit, ou encore dans le cas où, l'un seulement de ces deux contacts étant en court-circuit, l'autre contact est amené en position de fermeture consécutivement à l'excitation de la bobine qui commande cet autre contact. En effet, à l'exception de ces deux cas, l'intensité du courant qui, au cours de ce contrôle, circule dans l'enroulement E est, soit nulle, soit (dans le cas où le contact P est ouvert et le contact Q fermé) égale à une valeur $I_1$ qui est négligeable par rapport à celle du courant qui traverse cet enroulement lorsque celui-ci est normalement excité. C'est ainsi que, dans l'exemple décrit, d'après les valeurs de R1, R2, r et V2 qui ont été données plus haut, cette valeur $I_1$ est voisine de 0,5 mA, alors que celle du courant qui parcourt l'enroulement, lorsque celui-ci est normalement excité, est de l'ordre de 240 mA. En définitive, à l'exception des deux cas précités, l'intensité du courant qui traverse l'enroulement E, au cours de ce contrôle, est trop faible pour provoquer une excitation normale de cet enroulement.

Le dispositif de détection 10 qui est représenté sur la figure 1 peut, moyennant quelques adaptations mineures, servir pour détecter les coupures ou les court-circuits qui peuvent survenir dans un ensemble comportant plusieurs portions de circuit. Les figures 2A, 2B et 2C, assemblées comme l'indique la figure 2, montrent, à titre d'exemple, comment un tel dispositif de détection peut être agencé pour détecter les défauts d'un ensemble de commande destiné à commander les enroulements des têtes magnétiques d'un appareil d'enregistrement magnétique, cet appareil pouvant être, par exemple, celui qui a été accessoirement décrit dans le brevet des Etats-Unis d'Amérique US-A 4.205.120 (ce brevet correspondant au brevet français FR-A 2.402.921). Ainsi qu'on peut le voir sur les figures 2A, 2B et 2C, cet ensemble de commande, qui est destiné à commander l'excitation sélective de différents enroulements, tels que ceux qui sont désignés par E11, E12, etc ... sur ces figures, présente une structure de type matriciel. En d'autres termes, dans cette structure, les différents enroulements sont répartis en p groupes comprenant chacun n enroulements. C'est ainsi que le premier groupe comporte les enroulements E11, E12, ..., E1n, que le deuxième groupe comprend les enroulements E21, E22, ..., E2n, et ainsi de suite, le p ième groupe comprenant les enroulements Ep1, Ep2, ..., Epn. L'excitation sélective de ces enroulements est réalisée au moyen de n premiers organes interrupteurs P1, P2, ..., Pn qui sont associés chacun respectivement à un enroulement correspondant des n enroulements de chaque groupe, et de p seconds organes interrupteurs Q1, Q2, ..., Qp qui sont associés chacun respectivement à un groupe correspondant des p groupes d'enroulements. C'est ainsi, par exemple, que l'organe interrupteur P1 est associé aux enroulements E11, E21, E31, ..., Ep1, que l'organe interrupteur P2 est associé aux enroulements E12, E22, E32, ..., Ep2, et ainsi de suite. De même, l'organe interrupteur Q1 est associé au premier groupe d'enroulements, c'est-à-dire, aux enroulements E11, E12, ..., E1n, l'organe interrupteur Q2 est associé au deuxième groupe d'enroulements, c'est-à-dire aux enroulements E21, E22, ..., E2n, et ainsi de suite.

Dans l'exemple de réalisation illustré par les figures 2A, 2B et 2C, ces premiers organes interrupteurs P1, P2, ...,Pn sont constitués par des transistors de type PNP ayant chacun leur émetteur relié à la borne positive d'une source de tension T1, la borne négative de cette source étant reliée à la terre. Ces transistors ont leur borne de collecteur F1, F2, ..., Fn connectée à l'une des extrémités des enroulements auxquels ils sont associés, une diode, telle que D11, D12, ... ou Dpn, étant montée en série avec chacun de ces enroulements afin d'empêcher que ces derniers ne soient involontairement excités par des courants parasites. Ces transistors peuvent être rendus sélectivement passants, pendant un bref instant, grâce à des impulsions délivrées par une unité de commande UC et appliquées, par l'intermédiaire de n circuit "OU" UP1, UP2, ..., UPn, sur les bases de ces transistors, chacun de ces n circuits "OU" étant associé respectivement à un transistor correspondant de ces n transistors. On considèrera que les impulsions délivrées par cette unité de commande UC sont positives et que, en conséquence, n circuits inverseurs (non représentés) sont prévus pour inverser les signaux qui sont appliqués sur les bases de ces transistors, chacun de ces n circuits inverseurs étant intercalé entre la base de chacun des transistors P1 à Pn et le circuit "OU" associé à ce transistor.

Par ailleurs, les seconds organes interrupteurs Q1, Q2, ..., Qp sont constitués par des transistors de type NPN ayant chacun leur émetteur relié à la terre et leur collecteur connecté, par l'intermédiaire de l'une de p résistances r1, r2, ..., rp, à l'autre extrémité des enroulements du groupe auquel chacun de ces p transistors est associé. Ces p transistors peuvent être rendus sélectivement passants, pendant un bref instant, grâce à des impulsions délivrées par l'unité de commande UC et appliquées, par l'intermédiaire de p circuits "OU" UQ1, UQ2, ..., UQp, sur les bases de ces transistors, chacun de ces p circuits "OU" étant associé respectivement à chacun de ces p transistors.

Il est utile d'indiquer maintenant que les pn enroulements qui sont représentés sur les figures 2A, 2B et 2C entrent dans la constitution de pn têtes magnétiques, ces têtes servant à l'enregistrement d'informations sur un tambour magnétique entraîné en rotation de manière continue. Cependant, cet enregistrement ne s'effectue pas de façon permanente, mais il est au contraire interrompu régulièrement, pendant un temps très court, un peu avant la fin de chaque cycle de rotation de ce tambour, afin de laisser le temps nécessaire au regarnissage des mémoires qui, dans l'unité de commande UC, sont destinées à contenir temporairement les bits d'information servant à commander l'excitation sélective des enroulements des têtes magnétiques. On comprend alors que l'excitation sélective des pn enroulements se produit au cours de périodes, dites d'excitation normale des enroulements, ayant chacune une durée relativement longue, mais inférieure au temps mis par le tambour pour accomplir un tour, et que ces périodes d'excitation sont séparées les unes des autres par des périodes, dites de non excitation, ayant chacune une durée très courte. C'est précisément au cours de ces périodes de non excitation que le dispositif de détection représenté sur les figures 2A, 2B et 2C est mis en oeuvre pour vérifier l'état des différentes portions de circuit formées par les transistors P1 à Pn, les transistors Q1 à Qp, les pn enroulements E11, E12, etc., ..., ainsi que les diodes et résistances qui sont associées à ces enroulements ou à ces transistors.

Cependant, avant de donner des détails sur la structure et le fonctionnement de ce dispositif de détection, il est utile de signaler que, au cours des périodes d'excitation normale des enroulements, l'excitation sélective de ces enroulements est déclenchée par les impulsions qui, envoyées par l'unité de commande UC, sont appliquées sur les bases des transistors P1 à Pn et Q1 à QP, ces envois étant réalisés de telles sorte qu'à un instant donné, l'un au moins des transistors P1 à Pn et l'un au moins des transistors Q1 à Qp sont rendus passants. C'est ainsi, par exemple, que si, à un instant donné, les transistors P1, Pn, Q1 et Q2 sont rendus passants, les enroulements qui se trouvent simultanément parcourus par les courants délivrés par la source T1 sont comme on peut le voir sur les figures 2A et 2B, les enroulements E11, E1n, E21 et E2n. On peut voir, à cette occasion, que la diode D12 empêche que l'enroulement E12 soit parcouru, en sens inverse, par un courant parasite, issu de la dérivation des courants circulant dans les enroulements E11 et E1n, ce courant parasite ayant pour effet, si la diode D12 était supprimée, d'exciter, non seulement l'enroulement E12, mais également l'enroulement E22.

Le dispositif de détection qui est mis en oeuvre à la fin de chacune des périodes d'excitation normale des enroulements présente sensiblement la même structure que celle qui est illustrée sur la figure 1. En effet, sur les figures 2A, 2B et 2C assemblées, on retrouve le générateur de signaux G, la source de tension T2, les quatre amplificateurs différentiels AD1, AD2, AD3 et AD4, la résistance R2 et les circuits "ET" EA et EB. Cependant, du fait du nombre pn de portions de circuit à tester, ce dispositif de détection comporte, au lieu d'une seule résistance R1, n résistances R1-1, R1-2, ..., R1-n associées chacune respectivement à un organe interrupteur correspondant des n premiers organes interrupteurs P1 à Pn, ces n résistances étant montées en parallèle entre la borne positive de la source T2 et l'extrémité K de la résistance R2, ces n résistances ayant ainsi, comme le montrent les figures 2A et 2B, l'une de leurs extrémités connectée à la borne positive de T2 et leur autre extrémité J1, J2, ..., ou Jn connectée à la borne F1, F2, ..., ou Fn du premier organe interrupteur qui leur est associé. En outre, n diodes DM1, DM2, ..., DMn sont disposées, chacune respectivement entre chacune de ces autres extrémités J1, J2, ..., Jn et l'extrémité K de la résistance R2 afin d'empêcher la circulation de courants parasites. Par ailleurs, le générateur de signaux G comporte, au lieu de trois sorties, n + p + 1 sorties désignées, sur la figure 2A, par S0, S1, S2, ..., Sn, Sn + 1, Sn + 2, ..., Sn + p, les impulsions délivrées par la sortie S0 étant destinées à être appliquées sur l'une des entrées des circuits EA et EB. Les sorties S1, S2, ..., Sn du générateur G sont connectées chacune respectivement, d'une part, par l'intermédiaire de l'un des circuits "OU", UP1, UP2, ..., UPn, à la base d'un transistor correspondant des transistors P1, P2, ..., Pn, d'autre part à l'une des entrées d'un circuit "ET" correspondant de n circuits "ET" EC1, EC2, ..., ECn, ces n circuits "ET" ayant leur autre entrée connectée à la sortie X3 de l'amplificateur différentiel AD3. Les sorties Sn + 1, Sn + 2, ..., Sn + p du générateur G sont connectées chacune respectivement, d'une part, par l'intermédiaire de l'un des circuits "OU" UQ1, UQ2, ..., UQp, à la base d'un transistor correspondant des transistors Q1, Q2, ..., Qp, d'autre part à l'une des entrées d'un circuit "ET" correspondant de p circuits "ET" ED1, ED2, ..., EDp, ces p circuits "ET" ayant leur autre entrée connectée à la sortie X4 de l'amplificateur différentiel AD4. Enfin, pour permettre la mémorisation des signaux, de durée brève, délivrés par les circuits EA, EB, EC1, EC2, ..., ECn, ED1, ED2,..., EDp, le dispositif de détection comporte encore (n + p + 2) basculeurs désignés, sur la figure 2C, par BSP, BSQ, BCP1, BCP2, ..., BCPn, BCG1, BCG2, ..., BCGp, ces basculeurs étant associés chacun respectivement à un circuit correspondant des circuits EA, EB, EC1, EC2, ..., ECn, ED1, ED2, ..., EDp, chacun de ces basculeurs ayant son entrée "normale" connectée à la sortie de celui de ces circuits "ET" auquel il est associé. La remise à zéro de ces basculeurs est assurée, comme on le verra plus loin, par une impulsion délivrée par l'unité de commande UC et appliquée sur l'entrée "complémentaire" de tous ces basculeurs. La tension positive qui apparaît à la sortie "normale" de chacun des basculeurs BSP, BSQ, BCP1, BCP2, ..., BCPn, BCG1, BCG2, ..., BGCp, lorsque ceux-ci se trouvent à l'état "1", est appliquée, d'une part à chacun de (n + p + 2) éléments de visualisation LSP, LSQ, LCP1, LCP2, ..., LCPn, LCG1, LCG2, ..., LCGp associés chacun respectivement à chacun de ces basculeurs, d'autre part, par l'intermédiaire d'un circuit "OU" UR, à l'entrée d'un circuit inverseur IR, ce dernier ayant sa sortie connectée à l'une des deux entrées d'un circuit "ET" ER dont on parlera plus loin. Ces (n + p + 2) éléments de visualisation, qui sont constitués par des lampes, ont pour rôle d'indiquer à l'opérateur, lorsqu'ils s'allument, qu'un défaut a été détecté dans les portions de circuit à tester.

Il faut signaler que, dans le dispositif qui vient d'être décrit, chacune des résistances R1-1, R1-2, ..., R1-n a une valeur égale à celle de la résistance R1 mentionnée plus haut, et chacune des résistances r1, r2, ..., rp a une valeur égale à celle de la résistance r précitée. De même, on considèrera que l'on a encore, dans l'exemple ilustré sur les figures 2A, 2B et 2C :
V1 = 12 volts,

V2 = 5 volts,
V3 = 7 volts et,
V4 = 2 volts,
de sorte que l'on a alors :
V5 = 4 volts,
V6 = 25 millivolts.

Le fonctionnement du dispositif de détection qui est représenté sur les figures 2A, 2B et 2C est analogue à celui du dispositif de détection qui est illustré sur la figure 1. On signalera cependant que ce fonctionnement est déclenché par une impulsion qui est envoyée sur un conducteur C (figure 2A) par l'unité de commande UC à la fin d'une période d'excitation normale des enroulements E11, E12, ..., Epn, et qui est appliquée, d'une part sur l'entrée "complémentaire" des basculeurs afin de remettre ces derniers à zéro, d'autre part sur l'entrée MG du générateur de signaux G. En réponse à cette impulsion, le générateur G délivre une impulsion successivement sur chacune de ses sorties $S_0$, $S_1$, $S_2$, ..., $S_{n+p}$. C'est ainsi que la première impulsion est délivrée à la sortie $S_0$ de ce générateur et est appliquée sur l'une des entrées des circuits EA et EB.

Si aucun des transistors P1 à Pn et Q1 à Qp n'est en court-circuit, le point K se trouve porté, comme on l'a expliqué plus haut, au potentiel V5. Dans ce cas, aucun signal n'apparaît sur les sorties X1 et X2 de AD1 et AD2 et, par suite, les circuits EA et EB ne délivrent aucun signal à leur sortie, si bien que les basculeurs BSP et BSQ restent à zéro.

Si, au contraire, l'un au moins des transistors P1 à Pn se trouve en court-circuit, le point K se trouve porté au potentiel V1. Dans ce cas, un signal apparaît à la sortie X1 de AD1, ce qui provoque l'apparition d'un signal à la sortie du circuit EA, lequel, appliqué à l'entrée normale du basculeur BSP, a pour effet de mettre ce basculeur à l'état "1" et d'exciter ainsi l'élément LSP.

Si, maintenant, aucun des transistors P1 à Pn n'est en court-circuit, mais que l'un au moins des transistors Q1 à Qp est en court-circuit, le point K se trouve porté au potentiel V6, c'est-à-dire à un potentiel voisin de zéro. Dans ce cas, un signal apparaît à la sortie X2 de AD2, ce qui provoque l'apparition d'un signal à la sortie du circuit EB, lequel a alors pour effet de mettre le basculeur BSQ à l'état "1" et d'exciter ainsi l'élément LSQ.

La deuxième impulsion qui est ensuite délivrée à la sortie $S_1$ du générateur G est appliquée, d'une part, après inversion, à la base du transistor P1, ce qui a pour effet de rendre ce transistor passant, d'autre part, à l'une des entrées du circuit EC1.

Si aucune coupure ne s'est produite dans la portion de circuit comprise entre la borne + de T1 et la borne de collecteur F1 du transistor P1, le point K se trouve porté au potentiel V1. Dans ce cas, aucun signal n'apparaît à la sortie X3 de AD3 et, par suite, le circuit EC1 ne délivre aucun signal à sa sortie, si bien que le basculeur BCP1 reste à l'état "0".

Si, au contraire, une coupure s'est produite dans cette portion de circuit, le point K se trouve porté au potentiel V5. Dans ce cas, un signal apparaît à la sortie X3 de AD3. En conséquence, un signal apparaît à la sortie de EC1, ce qui a pour effet de mettre le basculeur BCP1 à l'état "1" et d'exciter l'élément LCP1.

De même, la troisième impulsion qui est délivrée ensuite à la sortie $S_2$ du générateur G est appliqué, d'une part, après inversion, à la base du transistor P2, ce qui rend ce transistor passant, d'autre part à l'une des entrées du circuit EC2. En raisonnant de la même manière que ci-dessus, on verrait alors que, en l'absence de coupure dans la portion de circuit comprise entre la borne + de T1 et la borne de collecteur F2 du transistor P2, le basculeur BCP2 reste à l'état "0", alors que, si une coupure s'est produite dans cette portion, ce basculeur BCP2 passe à l'état "1" et excite l'élément LCP2.

On ne décrira pas les actions provoquées par les impulsions qui sont ensuite délivrées successivement aux sorties $S_3$, $S_4$, ..., $S_n$ du générateur G pour la raison que ces actions sont similaires à celles provoquées par les impulsions délivrées aux sorties $S_1$ et $S_2$ de ce générateur. On indiquera simplement que si, d'une manière générale, une coupure s'est produite dans l'une quelconque des portions de circuit dans lesquelles se trouvent les transistors P3, P4, ..., Pn, cette coupure sera signalée par le passage à l'état "1" du basculeur correspondant, de sorte que l'opérateur pourra, d'après l'illumination des éléments LCP3, LCP4,..., LCP, déterminer celle ou celles de ces portions de circuit dans lesquelles une coupure a été détectée.

L'impulsion qui est alors délivrée à la sortie $S_{n+1}$ du générateur G est appliquée, d'une part sur la base du transistor Q1, ce qui rend ce transistor passant, d'autre part à l'une des entrées de circuit ED1.

Si aucune coupure ne s'est produite dans l'une quelconque des portions de circuit constituées chacune respectivement par chacun des enroulements E11, E12, ..., E1n du premier groupe, par chacune des diodes D11, D12, ..., D1n associées à ces enroulements, ainsi que par la résistance r1 et le transistor Q1, le point K se trouve alors porté au potentiel V6. Dans ce cas, aucun signal n'apparaît à la sortie X4 de AD4 et, par suite, le circuit ED1 ne délivre aucun signal à sa sortie. En conséquence, le basculeur BCG1 reste à l'état "0".

Si, au contraire, une coupure s'est produite dans l'une quelconque des portions de circuit précitées, par exemple dans la portion de circuit comprenant la diode D12, l'enroulement E12, la résistance r1 et le transistor Q1, le point K se trouve alors porté au potentiel V5. Dans ce cas, un signal apparaît à la sortie X4 de AD4. Par suite, un signal apparaît à la sortie de ED1, ce qui a pour effet de mettre le basculeur BCG1 à l'état "1" et d'exciter ainsi l'élément LCG1.

De la même manière, l'impulsion qui est délivrée ensuite à la sortie $S_{n+2}$ du générateur G est appliquée, d'une part sur la base du transistor Q2, ce qui rend ce transistor passant, d'autre part à l'une des entrées du circuit ED2. En raisonnant de la même manière que ci-dessus, on verrait alors que, dans le cas où aucune coupure ne s'est produite dans l'une quelconque des portions de circuit constituées chacune respectivement par chacun des enroulements E21, E22, ..., E2n du deuxième groupe, par chacune des diodes D21, D22, ..., D2n associées à ces enroulements, ainsi que par la résistance r2 et le transistor Q2, le basculeur BCG2 reste à l'état "0", alors que, si une coupure s'est produite dans l'une quelconque de ces portions de circuit, ce basculeur BCG2 passe à l'état "1" et excite alors l'élément LCG2.

On ne décrira pas les actions provoquées par les impulsions qui sont ensuite délivrées successivement aux sorties $S_{n+3}$, $S_{n+4}$, ..., $S_{n+p}$ du générateur G pour la raison que ces actions sont similaires à celles provoquées par les impulsions délivrées aux sorties $S_{n+1}$ et $S_{n+2}$ de ce générateur. On indiquera simplement que si, d'une manière générale, une coupure s'est produite dans l'une quelconque des portions de circuit constituées chacune respectivement par chacun des enroulements Ei1, Ei2, ..., Ein du ième groupe, par chacune des diodes Di1, Di2, ..., Din associées à ces enroulements, ainsi que par la résistance ri et le transistor Qi, cette coupure sera signalée par le passage à "1" du basculeur BCGi correspondant, de sorte que, à la fin du contrôle des portions de circuit du dernier groupe, l'opérateur pourra, d'après l'illumination des éléments LCG1, LCG2, ..., LCGp, déterminer dans quels groupes une coupure au moins a été détectée parmi les n portions de circuits de chacun de ces groupes. C'est ainsi, par exemple, que l'illumination de l'élément LCG3 signifiera qu'une coupure au moins s'est produite parmi les n portions de circuit du troisième groupe, c'est-à-dire parmi les portions de circuit constituées chacune respectivement par chacun des enroulements E31, E32, ..., E3n, et chacune des diodes D31, D32, ..., D3n qui sont associées à ces enroulements, ainsi que par la résistance r3 et le transistor Q3.

Dans l'exemple représenté sur la figure 2A, le générateur de signaux G est pourvu en outre d'une sortie supplémentaire SF et il est établi pour, après avoir délivré la $(n+p+1)$ième impulsion sur sa sortie $S_{n+p}$, délivrer une dernière impulsion sur cette sortie SF, cette dernière impulsion étant alors appliquée sur l'une des deux entrées du circuit "ET" ER, l'autre entrée de ce circuit étant connectée, ainsi qu'on l'a indiqué plus haut, à la sortie du circuit inverseur IR.

Dans le cas où, après que la $(n+p+1)$ième impulsion délivrée par la sortie $S_{n+p}$ du générateur G ait été appliquée à l'une des entrées du circuit EDp, aucun défaut n'a été détecté, c'est-à-dire dans le cas où tous les basculeurs BSP, BSQ, BCP1, BCP2, ..., BCPn, BCG1, BCG2, ..., BCGp sont restés à l'état "0", aucune tension positive n'est appliquée sur chacune des entrées du circuit UR. Par suite, aucune tension positive n'apparaît à la sortie de ce circuit UR et, par conséquent, une tension positive est délivrée à la sortie de l'inverseur IR et est appliquée à l'une des entrées du circuit ER. Dans ces conditions, ce circuit ER, lorsqu'il reçoit la dernière impulsion envoyée par la sortie SF du générateur G, délivre un signal à sa sortie et l'envoie à l'unité de commande UC, ce signal permettant ainsi d'avertir cette unité de l'absence de défaut à l'intérieur de l'ensemble qui a été contrôlé par le dispositif de détection. En réponse à la réception de ce signal, l'unité de commande UC peut alors, au cours d'une nouvelle période d'excitation normale, recommencer à envoyer les impulsions servant à déclencher l'excitation sélective des enroulements E11, E12,..., Epn, de la manière qui a été expliquée en détail plus haut.

Dans le cas où, au contraire, après l'envoi de la $(n+p+1)$ième impulsion par le générateur G, au moins un défaut a été détecté, l'un au moins des $(n+p+2)$ basculeurs se trouve alors à l'état "1". Par suite, une tension positive est présente à la sortie du circuit UR, de sorte que l'inverseur IR ne délivre aucune tension positive à sa sortie. Il en résulte que, lorsque le générateur G délivre une dernière impulsion sur sa sortie SF, le circuit ER, en réponse à la réception de cette impulsion, ne délivre aucun signal à sa sortie, de sorte que l'unité de commande UC, ne recevant aucun signal à la fin de la période de non-excitation, c'est-à-dire à la fin de la période au cours de laquelle le dispositif de détection a été mis en action est alors avertie de la présence d'au moins un défaut dans l'ensemble qui a été contrôlé par ce dispositif, et peut ainsi stopper l'envoi d'impulsions servant à déclencher l'excitation sélective des enroulements.

Il est utile d'indiquer que la période au cours de laquelle le dispositif de détection est mis en action est généralement très petite, comparée à celle d'excitation normale des enroulements. C'est ainsi, par exemple, que ce dispositif de détection, lorsqu'on l'utilise pour contrôler les circuits de commande d'excitation des enroulements des têtes servant à l'enregistrement d'informations sur un tambour magnétique entraîné en rotation à la vitesse de un tour par seconde, est capable de réaliser le contrôle des circuits de commande d'un ensemble comportant environ cent soixante enroulements, en un temps voisin de trente millisecondes, ce qui est très faible en comparaison de la période, d'une durée légèrement inférieure à une seconde, au cours de laquelle ces enroulements se trouvent sélectivement excités.

## Revendications

1. Dispositif (10) pour détecter les coupures et les court-circuits survenant dans au moins une portion de circuit électrique (11) formée d'au moins un élément passif non capacitif (E) présentant une première extrémité (F) et une seconde extrémité (H), d'un premier organe interrupteur (P) actionnable sélectivement et monté entre ladite première extrémité (F) et une première borne d'une source de tension continue (T1), et d'un second organe interrupteur (Q) actionnable sélectivement, indépendamment de l'actionnement dudit premier organe interrupteur, et monté entre ladite seconde extrémité (H) et la seconde borne de ladite source de tension (T1), ce dispositif (10) étant caractérisé en ce qu'il comprend un circuit discriminateur (AD1, AD2, AD3, AD4) pourvu d'une part, d'une entrée (K) connectée à ladite première extrémité (F), d'autre part de quatre sorties (X1, X2, X3, X4), ce circuit discriminateur (AD1, AD2, AD3, AD4) étant établi pour délivrer une configuration différente de signaux sur ses sorties (X1, X2, X3, X4), selon que chacune des deux parties de ladite portion de circuit (11) qui sont situées de part et d'autre de ladite première extrémité (F) présente un défaut de coupure ou un défaut de court-circuit, consécutivement à l'actionnement des deux organes interrupteurs (P et Q).

2. Dispositif de détection selon revendication 1, caractérisé en ce que, la première borne de la source de tension (T1) étant la borne positive (+) et la seconde borne de cette source étant la borne négative (-), le circuit discriminateur (AD1, AD2, AD3, AD4), est établi pour, lorsque lesdits organes interrupteurs (P et Q) sont sollicités en position d'ouverture, délivrer un signal sur sa première sortie (X1) dans le cas où ledit premier organe interrupteur (P) présente un défaut de court-circuit, et délivrer un signal sur sa deuxième sortie (X2) dans le cas où ledit second organe interrupteur (Q) présente un défaut de court-circuit, ce circuit discriminateur (AD1, AD2, AD3, AD4) étant établi en outre pour, lorsque uniquement ledit premier organe interrupteur (P) est sollicité en position de fermeture, délivrer un signal sur sa troisième sortie (X3) dans le cas où une coupure s'est produite entre ladite première extrémité (F) et ladite borne positive (+) de la source de tension (T1), et pour, lorsque uniquement ledit second organe interrupteur (Q) est sollicité en position de fermeture, délivrer un signal sur sa quatrième sortie (X4) dans le cas où une coupure s'est produite dans la partie de ladite portion de circuit (11) qui est comprise entre ladite première extrémité (F) et la borne négative (-) de cette source de tension (T1).

3. Dispositif de détection selon revendication 2, caractérisé en ce qu'il comprend en outre :
- une deuxième source de tension continue (T2) ayant sa borne négative (-) reliée à la borne négative (-) de la première source de tension continue (T1),
- une première résistance (R1) montée entre la première extrémité (F) de l'élément passif (E) et la borne positive (+) de ladite deuxième source de tension (T2),
- et une deuxième résistance (R2) ayant la première extrémité (K) reliée à la première extrémité (F) de l'élément passif (E) et son autre extrémité connectée à la borne négative (-) de cette deuxième source de tension (T2),
ces deux résistances (R1 et R2) ayant chacune une valeur très grande, comparée à celle de la résistance (r) dudit élément passif, ces deux résistances et ladite deuxième source de tension (T2) étant établies de telle sorte que, lorsque les deux organes interrupteurs (P et Q) sont placés en position d'ouverture, ladite première extrémité (K) de la seconde résistance est portée à un potentiel positif dont la valeur (V5) est notablement inférieure à celle (V1) du potentiel de la borne positive (+) de la première source de tension (T1).

4. Dispositif de détection selon revendication 2, caractérisé en ce que, pour permettre la détection des coupures et des court-circuits dans un ensemble comprenant, d'une part pn éléments passifs (E11, E12, ..., E1n, ..., Epn) répartis en p groupes comprenant chacun n éléments passifs (tels que E11, E12, ..., E1n), d'autre part n premiers organes interrupteurs (P1, P2, ..., Pn) associés chacun respectivement à chacun des n éléments de chaque groupe, et p seconds organes interrupteurs (Q1, Q2,..., Qp) associés chacun respectivement à chacun de ces p groupes, chacun de ces pn éléments ayant une première extrémité (telle que F1) reliée à la borne positive (+) de la source de tension (T1) par l'intermédiaire du premier organe interrupteur associé à cet élément, et son autre extrémité reliée à la borne négative (-) de cette source par l'intermédiaire du second organe interrupteur qui est associé au groupe dont cet élément fait partie, il comprend en outre :
- une deuxième source de tension continue (T2) ayant sa borne négative (-) reliée à la borne négative (-) de la première source de tension continue (T1),
- n premières résistances (R1-1, R1-2, ..., R1-n) associées chacune respectivement à chacun des n éléments de chaque groupe, chacune de ces résistances ayant l'une de ses extrémités reliée à la borne positive (+) de cette deuxième source de tension (T2) et son autre extrémité (telle que J1) reliée à la première extrémité (telle que F1) de l'élément passif qui est associé à cette résistance,
- et une deuxième résistance (R2) ayant une première extrémité (K) connectée, par l'intermédiaire de l'une de n diodes (telle que DM1), à l'autre extrémité (telle que J1) de chacune desdites premières résistances, et son autre extrémité connectée à la borne négative (-) de cette deuxième source de tension (T2),
ces n premières résistances ayant toutes la même valeur, la valeur de chacune d'elles et la valeur de la deuxième résistance étant très grandes, comparées à celle de la résistance (telle que r1) de chacun desdits éléments passifs, lesdites premières résistances, ladite seconde résistance et ladite deuxième source de tension étant établies de telle sorte que, lorsque lesdits premiers et seconds organes interrupteurs sont placés en position d'ouverture, ladite première extrémité (K) de cette seconde résistance (R2) est portée à un potentiel positif dont la valeur (V5) est notablement inférieure à celle (V1) du potentiel de la borne positive (+) de la première source de tension (T1).

5. Dispositif de détection selon l'une quelconque des revendications 3 et 4, caractérisé en ce que la valeur (V5) du potentiel de la première extrémité (K) de la seconde résistance (R2), lorsque les premiers et seconds organes interrupteurs sont ouverts, est pratiquement égale au tiers de la valeur (V1) du potentiel de la borne positive (+) de la première source de tension (T1).

6. Dispositif de détection selon l'une quelconque des revendications 3 à 5, caractérisé en ce que le circuit discriminateur est constitué de quatre amplificateurs différentiels (AD1, AD2, AD3, AD4) pourvus chacun d'une entrée inverseuse (-) et d'une entrée non inverseuse (+), les entrées inverseuses (-) du deuxième et du troisième amplificateurs (AD2 et AD3) et les entrées non inverseuses (+) du premier et du quatrième amplificateurs (AD1 et AD4) étant connectées entre elles à la première extrémité (K) de la seconde résistance (R2), l'entrée inverseuse (-) du premier amplificateur (AD1) et l'entrée non inverseuse (+) du troisième amplificateur (AD3) étant reliées à une première borne de potentiel de référence dont la valeur (V3) est intermédiaire entre la valeur (V1) du potentiel de la borne positive de la première source (T1) et la valeur (V5) du potentiel de ladite première extrémité (K) lorsque tous les organes interrupteurs P, Q, ou P1, P2, ..., Pn, Q1, Q2, ..., Qp sont placés en position d'ouverture, l'entrée non inverseuse (+) du deuxième amplificateur (AD2) et l'entrée inverseuse (-) du quatrième amplificateur (AD4) étant reliées à une seconde borne de potentiel de référence dont la valeur (V4) est inférieure à celle (V5) du potentiel de cette première extrémité lorsque tous ces organes interrupteurs sont placés en position d'ouverture.

7. Dispositif de détection selon revendication 6, caractérisé en ce qu'il comporte en outre :
- un premier circuit de validation (EA) et un deuxième circuit de validation (EB), ces deux circuits étant pourvus chacun d'une sortie et de deux entrées dont l'une est une entrée de validation, l'autre entrée de chacun de ces deux circuits étant connectée respectivement à chacune des sorties (X1 et X2) du premier et du deuxième amplificateurs (AD1 et AD2),
- et un générateur de signaux (G) pourvu d'une sortie ($S_0$) connectée à l'entrée de validation de chacun des deux circuits de validation (EA, EB), ce générateur étant établi pour délivrer sur cette sortie un signal de validation à un instant donné et pour appliquer ainsi ce signal simultanément à ces deux circuits de validation, de sorte que si, à cet instant, un premier organe interrupteur (P, P1, P2, ..., ou Pn) présente un défaut de court-circuit, un signal indicateur apparaît à la sortie du premier circuit de validation (EA), alors que si, à ce même instant, un second organe interrupteur (Q, Q1, Q2, ..., ou Qp) présente un défaut de court-circuit, un signal indicateur apparaît à la sortie du deuxième circuit de validation (EB).

8. Dispositif de détection selon revendication 7, caractérisé en ce que le générateur de signaux (G) est pourvu en outre de n sorties ($S_1$, $S_2$, ..., $S_n$) reliées chacune respectivement à chacun des n premiers organes interrupteurs (P1, P2, ..., Pn) et de p sorties ($S_{n+1}$, $S_{n+2}$, ..., $S_{n+p}$) reliées chacune respectivement à chacun des p seconds organes interrupteurs (Q1, Q2, ..., Qp), ce générateur étant établi pour délivrer un signal de validation sur successivement chacune de ses (n + p + 1) sorties afin que, en réponse à la réception de ces signaux de validation, ces (n + p) organes interrupteurs soient successivement sollicités en position de fermeture, les instants de délivrance et les durées de ces signaux de validation étant tels qu'un seul à la fois de ces organes interrupteurs se trouve sollicité dans cette position.

9. Dispositif de détection selon revendication 8, caractérisé en ce qu'il comporte en outre un premier ensemble comprenant n circuits de validation (EC1, EC2, ..., ECn) associés chacun respectivement à chacun des n premiers organes interrupteurs (P1, P2, ..., Pn) et pourvus chacun d'une sortie et de deux entrées dont l'une est une entrée de validation, l'autre entrée de ces n circuits étant connectée à la sortie (X3) du troisième amplificateur (AD3), les entrées de validation de ces n circuits étant connectées chacune respectivement à chacune des n sorties ($S_1$, $S_2$, ..., $S_n$) du générateur de signaux (G) afin de recevoir également les signaux de validation qui sont délivrés successivement sur ces sorties, de sorte que si, au moment où l'un quelconque desdits premiers organes interrupteurs est sollicité en position de fermeture, cet organe interrupteur présente un défaut de coupure, un signal indicateur apparaît à la sortie du circuit de validation qui est associé à cet organe interrupteur.

10. Dispositif de détection selon revendication 9, caractérisé en ce qu'il comporte encore un second ensemble comprenant p circuits de validation (ED1, ED2, ..., EDp) associés chacun respectivement à chacun des p seconds organes interrupteurs (Q1, Q2, ..., Qp) et pourvus chacun d'une sortie et deux entrées dont l'une est une entrée de validation, l'autre entrée de ces p circuits étant connectée à la sortie (X4) du quatrième amplificateur (AD4), les entrées de validation de ces p circuits étant connectées chacune respectivement à chacune des p sorties ($S_{n+1}$, $S_{n+2}$, ..., $S_{n+p}$) du générateur de signaux (G) afin de recevoir également les signaux de validation qui sont délivrés successivement sur ces sorties, de sorte que si, au moment où l'un quelconque desdits seconds organes interrupteurs est sollicité en position de fermeture, l'une au moins des portions de circuit comprenant ce second organe interrupteur et les n éléments passifs du groupe qui lui est associé présente un défaut de coupure, un signal indicateur apparaît à la sortie du circuit de validation qui est associé à ce second organe interrupteur.

**Patentansprüche**

1. Vorrichtung (10) zur Erfassung von Unterbrechungen und Kurzschlüssen, die in mindestens einem Stromkreisabschnitt (11) auftreten, der von mindestens einem passiven, nicht kapazitiven Element (E) gebildet wird, das ein erstes Ende (F) und zweites Ende (H) aufweist, von einem ersten selektiv betätigbaren Schaltorgan (P), das zwischen dem ersten Ende (F) und einem ersten Anschluß einer Gleitstromquelle (T1) geschaltet ist, und von einem zweiten, unabhängig von der Betätigung des ersten Schaltorgans selektiv betätigbaren Schaltorgan (Q), das zwischen dem zweiten Ende (H) und dem zweiten Anschluß der Spannungsquelle (T1) geschaltet ist, wobei diese Vorrichtung (10) dadurch gekennzeichnet ist, daß sie eine Diskriminatorschaltung (AD1, AD2, AD3, AD4) umfaßt, die einerseits mit einem an das erste Ende (F) angeschlossenen Eingang (K) und andererseits mit vier Ausgängen (X1, X2, X3, X4) versehen ist, und die Diskriminatorschaltung (AD1, AD2, AD3, AD4) dazu eingerichtet ist, eine unterschiedliche Signalkonfiguration über ihre Ausgänge (X1, X2, X3, X4) abzugeben, je nachdem, ob einer der beiden Teile dieses Stromkreisabschnitts (11), die sich beiderseits des ersten Endes (F) befinden, einen Unterbrechungsfehler oder einen Kurzschlußfehler aufweist, und zwar nach Betätigung der beiden Schaltorgane (P und Q).

2. Erfassungsvorrichtung nach Anspruch 1, dadurch gekennzeichnet, daß, da der erste Anschluß der Spannungsquelle (T1) der positive (+) Anschluß und der zweite Anschluß dieser Quelle der negative (–) Anschluß ist, die Diskriminatorschaltung (AD1, AD2, AD3, AD4) dazu eingerichtet ist, um, wenn diese Schaltorgane (P und Q) in offener Stellung sind, ein Signal über ihren ersten Ausgang (X1) in dem Fall abzugeben, daß das erste Schaltorgan (P) einen Kurzschlußfehler aufweist, und um ein Signal über ihren zweiten Ausgang (X2) in dem Fall abzugeben, daß das zweite Schaltorgan (Q) einen Kurzschlußfehler aufweist, wobei die Diskriminatorschaltung (AD1, AD2, AD3, AD4) außerdem dazu eingerichtet ist, um, wenn einzig und allein das erste Schaltorgan (P) in geschlossener Stellung ist, ein Signal über ihren dritten Ausgang (X3) in dem Fall abzugeben, daß zwischen dem ersten Ende (F) und dem positiven (+) Anschluß der Spannungsquelle (T1) eine Unterbrechung erfolgte, und um, wenn einzig und allein das Schaltorgan (Q) in geschlossener Stellung ist, ein Signal über ihren vierten Ausgang (X4) in dem Fall abzugeben, daß in dem Teil dieses Stromkreisabschnitts (11), der sich zwischen diesem ersten Ende (F) und dem negativen (–) Anschluß der Spannungsquelle (T1) befindet, eine Unterbrechung erfolgte.

3. Erfassungsvorrichtung nach Anspruch 2, dadurch gekennzeichnet, daß sie außerdem umfaßt:
– eine zweite Gleichspannungsquelle (T2), deren negativer (–) Anschluß mit dem negativen (–) Anschluß der ersten Gleichspannungsquelle (T1) verbunden ist,
– einen ersten Widerstand (R1), der zwischen dem ersten Ende (F) des passiven Elements (E) und dem positiven (+) Anschluß der zweiten Spannungsquelle (T2) geschaltet ist,
– und einen zweiten Widerstand (R2), dessen erstes Ende (K) mit dem ersten Ende (F) des passiven Elements (E) verbunden ist, und dessen anderes Ende mit dem negativen Anschluß (–) der zweiten Spannungsquelle (T2) verbunden ist, wobei jeder der beiden Widerstände (R1 und R2) einen sehr hohen Wert hat, verglichen mit dem des Widerstands (r) des passiven Elements, und die beiden Widerstände und die zweite Spannungsquelle (T2) dazu eingerichtet sind, daß wenn sich die beiden Schaltorgane (P und Q) in offener Stellung befinden, das erste Ende (K) des zweiten Widerstands auf ein positives Potential gebracht wird, dessen Wert (V5) merklich kleiner ist als der (V1) des Potentials des positiven (+) Anschlusses der ersten Spannungsquelle (T1).

4. Erfassungsvorrichtung nach Anspruch 2, dadurch gekennzeichnet, daß, um die Erfassung der Unterbrechungen und Kurzschlüsse in einer Baugruppe zu ermöglichen, die einerseits pn passive Elemente (E11, E12, ..., E1n, ..., Epn) umfaßt, die in p Gruppen aufgeteilt sind, von denen jede n passive Elemente umfaßt (wie z.B. E11, E12, ..., E1n), und andererseits n erste Schaltorgane (P1, P2, ..., Pn), die jeweils einem der n Elemente jeder Gruppe zugeordnet sind, und p zweite Schaltorgane (Q1, Q2, ..., Qp), die jeweils einer der p Gruppen zugeordnet sind, wobei jedes dieser pn Elemente ein erstes Ende (wie z.B. F1) hat, das mit dem positiven (+) Anschluß der Spannungsquelle (T1) durch das diesem Element zugeordnete erste Schaltorgan verbunden ist, und sein anderes Ende mit dem negativen (–) Anschluß dieser Quelle durch das zweite Schaltorgan verbunden ist, das der Gruppe, zu der dieses Element gehört, zugeordnet ist, außerdem enthaltend:
– eine zweite Gleichstromquelle (T2), deren negativer (–) Anschluß mit dem negativen (–) Anschluß der ersten Gleichspannungsquelle (T1) verbunden ist,
– n erste Widerstände (R1-1, R1-2, ..., R1-n), jeweils einem der n Elemente jeder Gruppe zugeordnet, wobei eines der Enden jedes dieser Widerstände mit dem positiven (+) Anschluß der zweiten Spannungsquelle (T2) und sein anderes Ende (wie z.B. J1) mit dem ersten Ende (wie z.B. F1) des passiven Elements verbunden ist, das diesem Widerstand zugeordnet ist,
– und einen zweiten Widerstand (R2), dessen erstes Ende (K) über eine der n Dioden (wie z.B. DM1) mit dem anderen Ende (wie z.B. J1) jedes der ersten Widerstände verbunden ist, und dessen anderes Ende mit dem negativen (–) Anschluß der zweiten Spannungsquelle (T2) verbunden ist, wobei diese n ersten Widerstände alle den gleichen Wert haben und der Wert eines jeden von ihnen sowie der Wert des zweiten Widerstands sehr groß ist verglichen mit dem des Widerstands (wie z.B. r1) jedes der passiven Elemente, wobei die ersten Widerstände, der zweite Widerstand und die zweite Spannungsquelle so eingerichtet sind, daß, wenn sich die ersten und zweiten Schaltorgane in geöffneter Stellung befinden, dieses erste Ende (K) dieses zweiten Widerstands (R2) auf ein positives Potential gebracht wird, dessen Wert (V5) merklich kleiner ist als der (V1) des Potentials am positiven Anschluß (+) der ersten Spannungsquelle (T1).

5. Erfassungsvorrichtung nach einem der Ansprüche 3 und 4, dadurch gekennzeichnet, daß der Wert (V5) des Potentials am ersten Ende (K) des zweiten Widerstands (R2), wenn die ersten und zweiten Schaltorgane geöffnet sind, faktisch gleich ist zu dem Drittel des Wertes (V1) des Potentials am positiven (+) Anschluß der ersten Spannungsquelle (T1).

6. Erfassungsvorrichtung nach einem der Ansprüche 3 bis 5, dadurch gekennzeichnet, daß die Diskriminatorschaltung vier Differenzverstärker (AD1, AD2, AD3, AD4) aufweist, von denen jeder mit einem invertierenden (–) Eingang und einem nicht invertierenden (+) Eingang versehen ist, wobei die invertierenden (–) Eingänge des zweiten und dritten Verstärkers (AD2 und AD3) und die nicht invertierenden (+) Eingänge des ersten und vierten Verstärkers (AD2 und AD4) untereinander mit dem ersten Ende (K) des zweiten Widerstandes (R2) verbunden sind, und der invertierende (–) Eingang des ersten Verstärkers (AD1) und der nicht invertierende (+) Eingang des dritten Verstärkers (AD3) mit einem ersten Bezugspotentialanschluß verbunden sind, dessen Wert (V3) zwischen dem Wert (V1) des Potentials am positiven Anschluß der ersten Spannungsquelle (T1) und dem Wert (V5) des Potentials dieses ersten Endes (K) liegt, wenn alle Schaltorgane P, Q, oder P1, P2, ..., Pn, Q1, Q2, ..., Qp in geöffneter Stellung sind, wobei der nicht invertierende (+) Eingang des zweiten Verstärkers (AD2) und der invertierende (–) Eingang des vierten Verstärkers (AD4) mit einem zweiten Bezugspotentialanschluß verbunden sind, dessen Wert (V4) kleiner als jener (V5) des Potentials dieses ersten Endes ist, wenn alle Schaltorgane in geöffneter Stellung sind.

7. Erfassungsvorrichtung nach Anspruch 6, dadurch gekennzeichnet, daß sie außerdem umfaßt:

– eine erste Freigabeschaltung (EA) und eine zweite Freigabeschaltung (EB), wobei jede dieser beiden Schaltungen mit einem Ausgang und zwei Eingängen versehen ist, von denen einer ein Freigabeeingang ist, und der andere Eingang jeder dieser beiden Schaltungen jeweils mit einem der Ausgänge (X1 und X2) des ersten und des zweiten Verstärkers (AD1 und AD2) verbunden ist,

– und einen Signalgenerator (G), versehen mit einem Ausgang (So), der mit dem Freigabeeingang jeder der beiden Freigabeschaltungen (EA, EB) verbunden ist, wobei dieser Generator dazu eingerichtet ist, auf diesem Ausgang ein Freigabesignal zu einem gegebenen Zeitpunkt abzugeben und somit dieses Signal gleichzeitig an diesen beiden Freigabeschaltungen so anzuwenden, daß, wenn zu diesem Zeitpunkt ein erstes Schaltorgan (P, P1, P2, ..., oder Pn) einen Kurzschlußfehler aufweist, ein Anzeigesignal am Ausgang der ersten Freigabeschaltung (EA) erscheint, während, wenn zum gleichen Zeitpunkt ein zweites Schaltorgan (Q, Q1, Q2, ..., oder Qp) einen Kurzschlußfehler aufweist, ein Anzeigesignal am Ausgang der zweiten Freigabeschaltung (EB) erscheint.

8. Erfassungsvorrichtung nach Anspruch 7, dadurch gekennzeichnet, daß der Signalgenerator (G) außerdem mit n Ausgängen (S1, S2, ..., Sn) versehen ist, von denen jeder jeweils mit einem der n ersten Schaltorgane (P1, P2, ..., Pn) verbunden ist, und mit p Ausgängen ($S_n + 1'$ $S_n + 2'$ ..., $S_n + p$), von denen jeder jeweils mit einem der p zweiten Schaltorgane (Q1, Q2, ..., Qp) verbunden ist, wobei dieser Generator dazu eingerichtet ist, ein Freigabesignal nacheinander auf jedem seiner (n + p +1) Ausgänge abzugeben, damit, in Beantwortung des Empfangs dieser Freigabesignale, die (n + p) Schaltorgane nacheinander in eine geschlossene Stellung angezogen werden, wobei die Zeitpunkte der Signalabgabe und die Dauer dieser Freigabesignale derart sind, daß sich nur ein einziges dieser Schaltorgane auf einmal in dieser Stellung befindet.

9. Erfassungsvorrichtung nach Anspruch 8, dadurch gekennzeichnet, daß sie außerdem eine erste Baugruppe umfaßt, die n Freigabeschaltungen (EC1, EC2, ..., ECn) enthält, deren jede jeweils einem der n ersten Schaltorgane (P1, P2, ..., Pn) zugeordnet ist und deren jede mit einem Ausgang und zwei Eingängen versehen ist, von denen einer ein Freigabeeingang ist und der andere Eingang dieser n Schaltungen mit dem Ausgang (X3) des dritten Verstärkers (AD3) verbunden ist, wobei jeder Freigabeeingang dieser n Schaltungen jeweils mit einem der n Ausgänge (S1, S2, ..., Sn) des Signalgenerators (G) verbunden ist, um ebenfalls die Freigabesignale zu erhalten, die nacheinander über diese Ausgänge abgegeben werden, so daß, wenn in dem Augenblick, wo irgendeines der ersten Schaltorgane in geschlossener Stellung ist, dieses Schaltorgan einen Unterbrechungsfehler aufweist, ein Anzeigesignal am Ausgang der diesem Schaltorgan zugeordneten Freigabeschaltung erscheint.

10. Erfassungsvorrichtung nach Anspruch 9, dadurch gekennzeichnet, daß sie noch eine zweite Baugruppe umfaßt, die p Freigabeschaltungen (ED1, ED2, ..., EDp) enthält, die jeweils einem der p zweiten Schaltorgane (Q1, Q2, ..., QP) zugeordnet sind und jede mit einem Ausgang und zwei Eingängen versehen sind, von denen einer ein Freigabeeingang ist, wobei der andere Eingang dieser p Schaltungen mit dem Ausgang (X4) des vierten Verstärkers (AD4) verbunden ist und jeder der Freigabeeingänge dieser p Schaltungen jeweils mit einem der p Ausgänge ($S_n + 1'$ $S_n + 2'$ ..., $S_n + p$) des Signalgenerators (G) verbunden ist, um ebenfalls die Freigabesignale zu empfangen, die nacheinander über diese Ausgänge abgegeben werden, so daß, wenn im Augenblick, wo irgendeines dieser zweiten Schaltorgane in geschlossener Stellung ist, mindestens einer der Schaltungsabschnitte, der dieses zweite Schaltorgan und die n passiven Elemente der Gruppe enthält, die ihm zugeordnet ist, einen Unterbrechungsfehler aufweist, ein Anzeigesignal am Ausgang der diesem zweiten Schaltorgan zugeordneten Freigabeschaltung erscheint.

## Claims

1. A device for detecting cutoffs and short-circuit defects occurring in at least one electrical circuit portion (11) having at least one passive, non-capacitive element (E) and including a first end (F) and a second end (H), a first switch member (P) selectively actuatable and mounted between said first end (F) and a first terminal of a source of direct voltage (T1), and a second switch member (Q) selectively actuatable, independently of said first switch member, and mounted between said second end (H) and the second terminal of said voltage source (T1), said device (10) being characterised in that it comprises a discriminator circuit (AD1, AD2, AD3, AD4) provided on one hand, with an input (K) connected to said first end (F) and, on the other hand, with four outputs (X1, X2, X3, X4), this discriminator circuit (AD1, AD2, AD3, AD4) being arranged to deliver a different configuration of signals at its outputs (X1, X2, X3, X4), depending on whether each of the two parts of the circuit portion (11) located on either side of said first end (F) have a cutoff defect or a short-circuit defect, consecutively to the actuation of the two switch members (P and Q).

2. A detection device according to claim 1, characterized in that, with the first terminal of the voltage source (T1) being the positive terminal (+) and the second terminal of said source being the negative terminal (–), the discriminator circuit (AD1, AD2, AD3, AD4) is arranged so that, when said switch members (P and Q) are urged in the opening position, it delivers a signal at its first output (X1) in the case where said first switch member (P) has a short-circuit defect, and it furnishes a signal at its second output (X2) in the case where said second switch member (Q) has a short-circuit defect, said discriminator circuit (AD1, AD2, AD3, AD4) being further arranged so that, when only said first switch member (P) is urged in the closing position it delivers a signal at its third output (X3) in the case where a cutoff has occurred between said first end (F) and said positive terminal (+) of the voltage source (T1), and, when only said second switch member (Q) is urged in the closing position, it delivers a signal at its fourth output (X4) in the case where a cutoff has occurred in the part of said circuit portion (11) that is included between said first end (F) and the negative terminal (–) of this voltage source (T1).

3. A detection device according to claim 2, characterized in that it further includes:
   – a second source of direct voltage (T2) having its negative terminal (–) connected to the negative terminal (–) of the first source of direct voltage (T1),
   – a first resistor (R1) connected between the first end (F) of the passive element (E) and the positive terminal (+) of said second voltage source (T2),
   – and a second resistor (R2) having the first end (K) connected to the first end (F) of the passive element (E) and having its other end connected to the negative terminal (–) of said second voltage source (T2), said two resistors (R1 and R2) each having a very large value compared to that of the resistor (r) of said passive element, said two resistors and said second voltage source (T2) being arranged such that, when the two switch members (P and Q) are placed in the opening position, said first end (K) of the second resistor is carried to a positive potential the value (V5) of which is notably less than that (V1) of the potential of the positive terminal (+) of the first voltage source (T1).

4. A detection device according to claim 2, characterized in that to permit the detection of cutoffs and short circuit defects in an assembly including on the one hand pn passive elements (E11, E12, ..., E1n, ...., Epn) distributed into p groups each including n passive elements (such as E11, E12, ..., E1n), and on the other hand n first switch members (P1, P2, ..., Pn) each associated respectively with each of the n elements of each group, and p second switch members (Q1, Q2, ..., Qp) each associated
   – respectively with each of these p groups, each of these pn elements having a first end (such as F1) connected to the positive terminal (+) of the first voltage source (T1) via the first switch member associated with that element, and its other end connected to the negative terminal (–) of this source via the second switch member which is associated with the group to which this element belongs, it further comprises
   – a second source of direct voltage (T2) having its negative terminal (–) connected to the negative terminal (–) of the first source of direct voltage (T1),
   – n first resistors (R1-1, R1-2, ..., R1-n) each associated respectively with each of the n elements of each group, each of these resistors having one of its ends connected to the positive terminal (+) of said second voltage source (T2) and its second end (such as J1) connected to the first end (such as F1) of the passive element which is associated with that resistor,
   – and a second resistor (R2) having a first end (K) connected, via one of n diodes (such as DM1), to the other end (such as J1) of each of said first resistors, and its other end connected to the negative terminal (–) of said second voltage source (T2), said n first resistors all having the same values, the value of each of them and the value of the second resistor being very large compared with that of the resistor (such as r1) of each of said passive elements, said first resistors, said second resistor and said second voltage source being arranged such that, when said first and second switch members are placed in the opening position, said first end (K) of said second resistor (R2) is carried to a positive potential the value (V5) of which is notably less than that (V1) of the potential of the positive terminal (+) of the first voltage source (T1).

5. A detection device according to either one of claims 3 and 4, characterized in that the value (V5) of the potential of the first end (K) of the second resistor (R2), when the first and second switch members are open, is practically equal to one-third of the value (V1) of the potential of the positive terminal (+) of the first voltage source (T1).

6. A detection device according to any one of the claims 3 to 5, characterized in that the discriminator circuit comprises four differential amplifiers (AD1, AD2, AD3, AD4), each provided with an inverting input (–) and a non-inverting input (+), the inverting inputs (–) of the second and third amplifiers (AD2 and AD3) and the noninverting inputs (+) of the first and fourth amplifiers (AD1 and AD4) being connected among one another to the first end (K) of the second resistor (R2), the inverting input (–) of the first amplifier (AD1) and the non-inverting input (+) of the third amplifier (AD3) being connected to a first terminal of reference potential, the value (V3) of which is between the value (V1) of the potential of the positive terminal of the first source (T1) and the value (V5) of the potential of said first end (K) when all the switch members (P, Q or P1, P2, ..., Pn, Q1, Q2, ..., Qp) are placed in the opening position, the non-inverting input (+) of the second amplifier (AD2) and the inverting input (–) of the fourth amplifier (AD4) being connected to a second terminal of reference potential, the value (V4) of which is less than that (V5) of the potential of this first end when all these switch members are placed in the opening position.

7. A detection device according to claim 6, characterized in that it further includes:
   – a first validation circuit (EA) and a second validation circuit (EB), these two circuits being each provided with one output and two inputs, one of which is a validation input, the other input of each of these two circuits being connected respectively to each of the outputs (X1 and X2) of the first and second amplifiers (AD1 and AD2),

— and a signal generator (G) provided with an output (SO) connected to the validation input of each of the two validation circuits (EA, EB), this generator being arranged to deliver at its output a validation signal at a given instant and thus to apply this signal simultaneously to these two validation circuits, such that if at this instant a first switch member (P, P1, P2, ..., or Pn) has a short-circuit defect, an indicator signal appears at the output of the first validation circuit (EA), while if at this same instant a second switch member (Q, Q1, Q2, ..., or Qp) has a short-circuit defect, an indicator signal appears at the output of the second validation circuit (EB).

8. A detection device according to claim 7, characterized in that the signal generator (G) is further provided with n outputs (S1, S2, ..., Sn) each respectively connected to each of the n first switch members (P1, P2, ..., Pn) and with p outputs (Sn+1, Sn+2, ..., Sn+p) each connected respectively with each of the p second switch members (Q1, Q2, ..., Qp), this generator being arranged to deliver a validation signal successively at each of its (n + p + 1) outputs, so that in response to the reception of these validation signals, these (n + p) switch members will be successively urged into the closing position, the instants of deliverance and the durations of these validation signals being such that only one at a time of these switch members are urged into this position.

9. A detection device according to claim 8, characterized in that it further includes a first assembly including n validation circuits (EC1, EC2, ..., ECn) each associated respectively with each of the n first switch members (P1, P2, ..., Pn) and each provided with one output and two inputs, one of which is a validation input, the other input of these n circuits being connected to the output (X3) of the third amplifier (AD3), the validation inputs of these n circuits being connected each respectively to each of the n outputs (S1, S2, ..., Sn) of the signal generator (G) so as likewise to receive the validation signals which are delivered successively at these outputs, such that if at the moment when any one of said first switch member is urged into the closing position that switch member has a cutoff defect, an indicator signal appears at the output of the validation circuit that is associated with that switch member.

10. A detection device according to claim 9, characterized in that it further includes a second assembly comprising p validation circuits (ED1, ED2, ..., EDp) each associated respectively with each of p second switch members (Q1, Q2, ..., Qp) and each being provided with one output and two inputs, one of which is a validation input, the other input of these p circuits being connected to the output (X4) of the fourth amplifier (AD4), the validation inputs of these p circuits being connected each respectively to each of the p outputs (Sn+1, Sn+2, ..., Sn+p) of the signal generator (G) so as likewise to receive the validation signals which are delivered successively at these outputs, such that if, at the moment when any one of said second switch devices is urged into the closing position, at least one of the circuit portions including that second switch and the n passive elements of the group with which it is associated has a cutoff defect, an indicator signal appears at the output of the validation circuit which is associated with that second switch member.

EP 0 341 117 B1

**FIG.1**

**FIG.2**

| FIG.2A | FIG.2B | FIG.2C |
|--------|--------|--------|

## FIG.2A

FIG.2B

FIG.2C